# EUROPÄISCHE PATENTSCHRIFT

(11) **EP 0 940 482 B1**
(45) Veröffentlichungstag und Bekanntmachung des Hinweises auf die Patenterteilung: **28.05.2003**
(21) Anmeldenummer: 99104321.7
(22) Anmeldetag: 04.03.1999
(51) Int. Cl.: C23C 14/50, H01J 37/00, C23C 14/24, C23C 14/32

(54) **Vakuum-Plasma-Beschichtungsanlage und Anwendung derselben**
Vacuum plasma coating apparatus and its use
Dispositif pour le revêtement sous vide assité par plasma et utilisation

(30) Priorität: 06.03.1998 DE 19809663
(43) Veröffentlichungstag der Anmeldung: 08.09.1999
(73) Patentinhaber: VTD Vakuumtechnik Dresden GmbH, 01257 Dresden (DE)
(72) Erfinder: Falz, Michael, 01169 Dresden (DE); Bücken, Bernd, 01277 Dresden (DE); Wilberg, Rüdiger, 01259 Dresden (DE)
(74) Vertreter: Pätzelt, Peter, Dipl.-Ing.

(56) Entgegenhaltungen:
- DD-A- 300 782

## Beschreibung

Die Erfindung betrifft eine Vakuum-Plasma-Beschichtungsanlage bestehend aus einer horizontalen Vakuumkammer, einer darin angeordneten Substrathalterung, mittels der die Substrate während der Beschichtung um mindestens eine horizontale Achse rotieren und mindestens einem Vakuum-Lichtbogenverdampfer.

Des weiteren betrifft die Erfindung die Anwendung der erfindungsgemäßen Vakuum-Plasma-Beschichtungsanlage.

Nach dem Stand der Technik sind verschiedene Bauarten horizontaler Vakuumbeschichtungsanlagen bekannt. Dabei sind die Substrate vielfach in Substratträgern angeordnet, derart daß einzelne Substratträger mit den Substraten als Planeten innerhalb eines Drehkorbes auf einem zugehörigen Wagen angeordnet sind, wobei der Drehkorb selbst eine Rotationsbewegung ausführt.

Als Beschichtungsquellen können grundsätzlich alle bekannten Arten eingesetzt werden. Im einzelnen sind das im wesentlichen die thermischen Vakuumverdampfer, Elektronenstrahlverdampfer, Kathodenzerstäubungseinrichtungen oder Vakuum-Lichtbogenverdampfer. Die praktische Auswahl richtet sich nach dem vorgesehenen Einsatzzweck der Anlage, d.h. danach welche Substrate wie beschichtet werden sollen sowie nach ökonomischen Gesichtspunkten. In jüngerer Zeit werden bevorzugt Vakuum-Beschichtungsanlagen eingesetzt, mit denen der Beschichtungsprozeß plasmagestützt erfolgen kann. Die plasmagestützte Schichtabscheidung hat den Vorteil, daß die Schichten vielfach eine bessere Haftung und größere Dichte aufweisen, was zu vorteilhaften Eigenschaften führt.

Die Beschichtungsquellen werden im allgemeinen zentrisch innerhalb des Rotationskreises der Substratträger im Drehkorb angeordnet. Es ist aber auch möglich die Beschichtungsquellen an der Peripherie der Vakuumkammer anzuordnen. Die Geometrie der Beschichtungsquellen wird dabei grundsätzlich an die Geometrie der Substrate bzw. die entsprechenden Substratträger angepaßt, damit möglichst eine große Menge des verdampften oder zerstäubten Materials gleichmäßig auch auf den Substraten abgeschieden wird.

Die Druckschrift DD 300 782 A7 beschreibt eine Beschichtungsanlage mit horizontaler Vakuumkammer, einer Drehtrommel mit horizontaler Achse für Schüttgut, zwei Magnetrons mit unterschiedlicher Targetbestückung innerhalb des Drehkreises der Trommel und zwischen den Magnetrons angeordnete Blenden zur Trennung der Beschichtungsräume beim Plasmaabscheiden des Schichtsystems CrSi-Oxid/NiCr

Beim Einsatz thermischer Verdampfer oder anderer Verdampfer mit einem Schmelzbad aus dem das Beschichtungsmaterial verdampft wird, können diese in der Praxis nur so angeordnet werden, daß die Verdampfung nach oben erfolgt.

Die Druckschrift JP 62-2253762 A gibt eine simulate Abscheidung unterschiedlich verdampfbarer Materialien an, wobei Zn mittels thermischer Verdampfung und Zn-Ni- oder Zn-Fe-Legierung mittels Lichtbogen verdampft werden.

Bei der bereits beschriebenen konzentrischen Rotation der Substrate in einer Substrathalterung werden dabei im wesentlichen immer nur die Substrate beschichtet, die sich oberhalb des Verdampfers innerhalb der Verdampfungswolke befinden.

Die anderen Beschichtungsquellen wie die Kathodenzerstäubungseinrichtungen oder die kathodischen Vakuum-Lichtbogenverdampfer können auch seitlich oder oberhalb der Substrate angeordnet werden.

Die Lösungen nach dem Stand der Technik sind grundsätzlich immer für einen bestimmten Einsatzzweck ausgerichtet und ein Umrüsten für einen anderen Einsatzzweck ist oft sehr aufwendig und mit erheblichen baulichen Veränderungen verbunden.

Wenn unterschiedliche Beschichtungsquellen eingesetzt werden sollen, dann werden in der Regel auch unterschiedliche Anlagen eingesetzt.

Bei Beschichtungsaufgaben, bei denen verschiedene Materialien verdampft bzw. zerstäubt werden müssen, werden jeweils gleichartige Verdampfer mit unterschiedlichen Bedampfungsmaterialien bestückt und parallel oder alternativ betrieben.

Der Erfindung liegt als Aufgabe zugrunde, als Einrichtung eine Vakuum-Plasma-Beschichtungsanlage der eingangs genannten Art anzugeben, mit der es möglich ist, unterschiedliche Materialien mit hoher Abscheidungsgeschwindigkeit abzuscheiden.

Die Erfindung löst die Aufgabe für die Einrichtung durch die im kennzeichnenden Teil des Anspruchs 1 genannten Merkmale.

Die Aufgabe zur Anwendung der Einrichtung wird durch die Merkmale des Anspruchs 9 gekennzeichnet.

Vorteilhafte Weiterbildungen der Erfindung sind in den jeweiligen Unteransprüchen gekennzeichnet und werden nachstehend zusammen mit der Beschreibung der bevorzugten Ausführung der Erfindung, einschließlich der Zeichnung, näher dargestellt.

Der Kern der Erfindung besteht darin, daß innerhalb einer horizontalen Vakuum-Plasma-Beschichtungsanlage mit mindestens einem Vakuum-Lichtbogenverdampfer zusätzlich auch mindestens ein thermischer Verdampfer angeordnet ist. Durch diese Parallelanordnung von verschiedenen Verdampfern ist es in vorteilhafter Weise möglich, aus dem thermischen Verdampfer mit hoher Rate solche Materialien wie Aluminium oder Kupfer zu verdampfen. In unmittelbarer Folge können alle anderen Materialien, die vorteilhaft plasmagestützt abgeschieden werden, in effektiver Weise mit einem Vakuum-Lichtbogenverdampfer verdampft werden.

Dabei sind unterschiedliche Kombinationen möglich. In bekannter Weise kann mit dem Vakuum-Lichtbogenverdampfer zuerst eine haftfeste Grundschicht abgeschieden werden oder abschließend eine plasmagestützt abgeschiedene Deckschicht.

Die Erfindung kann beispielsweise vorteilhaft eingesetzt werden, wenn eine elektrisch gut leitfähige Schicht, z. B. aus Aluminium oder Kupfer mit einer Korrosionsschutzschicht geschützt werden soll. Aluminium und Kupfer lassen sich sehr gut und mit hoher Geschwindigkeit aus einem thermischen Verdampfer verdampfen. Materialien für Korrosionsschutzschichten wie Ni, Cr oder NiCr sind dagegen bei der thermischen Verdampfung sehr reaktiv und führen zu einem überhöhten Verschleiß an Verdampferwendeln bzw. derartige Materialien sind praktisch nicht thermisch zu verdampfen. Deshalb ist es vorteilhaft diese Materialien von einem Vakuum-Lichtbogenverdampfer zu verdampfen.

Die Erfindung wird nachstehend an einem Ausführungsbeispiel näher erläutert werden.

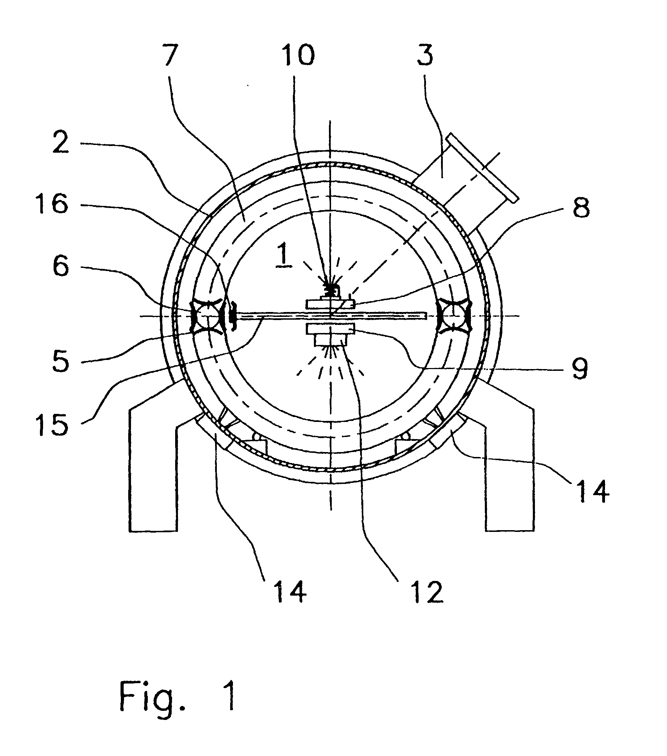

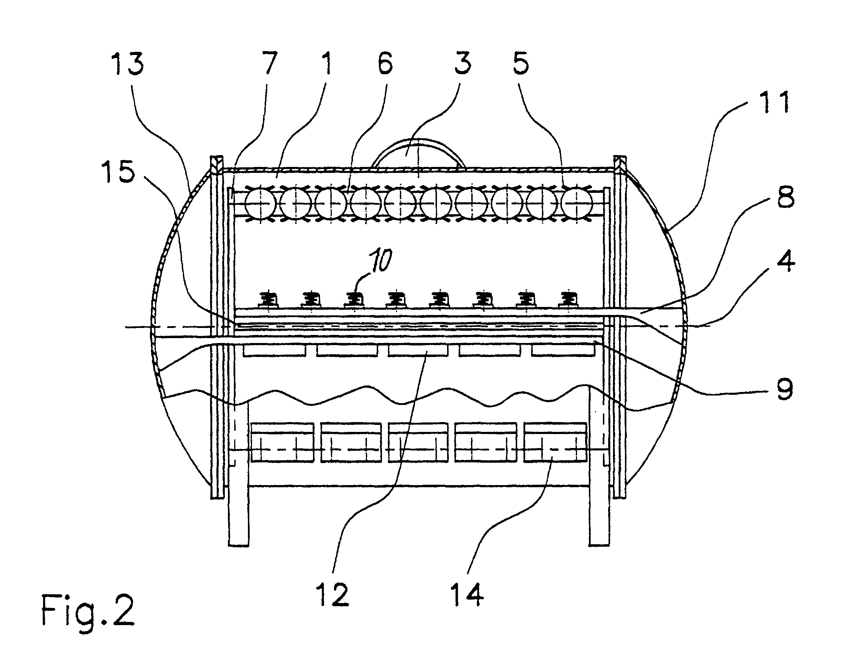

Die Zeichnung zeigt eine erfindungsgemäße Vakuum-Plasma-Beschichtungsanlage in schematischer Darstellung. Figur 1 zeigt einen Schnitt durch die Vorderansicht und Figur 2 zeigt die Seitenansicht von Figur 1.

Figur 1 zeigt eine Vakuumkammer 1 mit einer Wandung 2 und einem Pumpstutzen 3, über den die Vakuumkammer 1 von einer Vakuum-Pumpeinrichtung evakuiert werden kann. Die Hauptachse 4 der Vakuumkammer 1 liegt in einer horizontalen Ebene. Die zu beschichtenden Substrate 5 sind in einer Substrathalterung 6 gehaltert, wovon mehrere drehbar in einem Drehkorb 7 gelagert sind. Der Drehkorb 7 ist auf einem fahrbaren wagenartigen Gestell gelagert, derart daß die Substrate 5 außerhalb der Vakuumkammer 1 leicht an den Substrathalterungen 6 gehaltert werden können und zum Beschichten koaxial zur Hauptachse 4 in der Vakuumkammer 1 positioniert werden können. Zur Beschichtung dreht sich der Drehkorb 7 und die Substrate 5 bewegen sich planetenartig um die Hauptachse 4.

Zentrisch zum Drehkorb 7 befindet sich in der oberen Hälfte der Vakuumkammer 1 ein Verdampferträger 8 und unterhalb von diesem ein Verdampferträger 9.

Der Verdampferträger 8 dient als Träger für mehrere thermische Verdampfer 10 und ist an einer stirnseitigen Vakuumkammertür 11, die in Figur 2 ersichtlich ist, gehaltert. Eine Vielzahl der thermischen Verdampfer 10 sind so ausgerichtet, daß sich das verdampfte Material auf den Substraten 5 abscheidet, die sich oberhalb der thermischen Verdampfer 10 befinden. In diesem Bereich ist im Beispiel noch eine Glimmelektrode 16 angeordnet.

Der Verdampferträger 9 dient als Träger für mehrere Vakuum-Lichtbogenverdampfer 12 und ist an der anderen stirnseitigen Vakuumkammertür 13 gehaltert. Die einzelnen Vakuum-Lichtbogenverdampfer 12 sind dabei hintereinander parallel zur Hauptachse 4 angeordnet und das verdampfte Material wird nach unten abgedampft. Im unteren Abschnitt der Wandung 2 der Vakuumkammer 1 sind symmetrisch zwei weitere Reihen Vakuum-Lichtbogenverdampfer 14 angeordnet, von denen das verdampfte Material in zentrische Richtung zur Hauptachse 4 hin abgedampft wird.

Zwischen dem oberen Abschnitt der Vakuumkammer 1 mit den thermischen Verdampfern 10 und dem entsprechenden unteren Abschnitt mit den Vakuum-Lichtbogenverdampfer 12 und 14 befindet sich noch eine Blende 15, die im wesentlichen das Eindringen von Dämpfen aus dem jeweils anderen Abschnitt der Vakuumkammer 1 verhindern soll.

Beispielhaft soll in dieser erfindungsgemäßen Einrichtung auf den Substraten 5 eine elektromagnetische Abschirmschicht hergestellt werden. Sie Substrate 5 bestehen aus einem Plastmaterial. Die elektromagnetische Abschirmschicht soll aus einer ca. 5µm dicken Kupferschicht aufgebaut werden, die mit einer 150nm dicken Nickel-Chromschicht gegen Korrosion geschützt werden soll.

Verfahrensgemäß wird nach der Einbringung der Substrate 5 die Vakuumkammer 1 evakuiert und die Substrate 5 in einem ersten Schritt bei einer planetenartigen Bewegung um die Hauptachse 4 in einer Glimmentladung mittels der Glimmelektrode 16 einer Reinigung unterzogen. Danach werden die thermischen Verdampfer 10 an Spannung gelegt und das vorher eingebrachte Kupfer restlos verdampft. Die Menge des Kupfers ist empirisch so bemessen, daß die auf den Substraten 5 abgeschiedene Schicht die gewünschte Dicke von ca. 2,5µm aufweist.

Unmittelbar nach dem Abschalten der thermischen Verdampfer 10 werden die Vakuum-Lichtbogenverdampfer 12 und 14 in Betrieb genommen und mit einem abgestimmten Zeitregim auf den Substraten 5 mit der Kupferschicht eine 150nm dicke Nickel-Chromschicht abgeschieden.

Der besondere Vorteil der Einrichtung und des Verfahrens zur Anwendung derselben besteht darin, daß mit sehr einfachen Mitteln, ohne technologische Unterbrechung und mit hoher Abscheidungsgeschwindigkeit die relativ dicke leitfähige Schicht aus Kupfer abgeschieden werden kann und die dünnere Nickel-Chromschicht mit dem effektiven plasmagestützten Verfahren mittels der Vakuum-Lichtbogenverdampfer 12 und 14.

Die Erfindung ist selbstverständlich nicht auf das beschriebene Ausführungsbeispiel beschränkt. So ist es ohne weiteres möglich, die beiden Verdampfertypen parallel zu betreiben und Mischschichten abzuscheiden.

Je nach den konkreten Anforderungen könnte die Verdampfung des Kupfers auch in einem Plasma erfolgen. Dazu kann einer der Vakuum-Lichtbogenverdampfer 12 oder 14 mit geringer Leistung oder gegen eine Blende betrieben werden. Auch können die beiden Verdampferarten gemeinsam betrieben werden und z.B. in Übergangszonen eine Mischschicht abgeschieden werden.

### Liste der verwendeten Bezugszeichen

| | | | |
|---|---|---|---|
| 1 | Vakuumkammer | 2 | Wandung |
| 3 | Pumpstutzen | 4 | Hauptachse |
| 5 | Substrat | 6 | Substrathalterung |
| 7 | Drehkorb | 8 | Verdampferträger |
| 9 | Verdampferträger | 10 | thermischer Verdampfer |
| 11 | Vakuumkammertür | 12 | Vakuum-Lichtbogenverdampfer |
| 13 | Vakuumkammertür | 14 | Vakuum-Lichtbogenverdampfer |
| 15 | Blende | 16 | Glimmelektrode |
| 17 | | 18 | |
| 19 | | 20 | |

## Patentansprüche

1. Vakuum-Plasma-Beschichtungsanlage bestehend aus einer horizontalen Vakuumkammer (1), einer darin angeordneten Substrathalterung (6), mittels der Substrate (5) während der Beschichtung um mindestens eine horizontale Achse (4) rotieren, mindestens einem Vakuum-Lichtbogenverdampfer (12, 14) und mindestens einem innerhalb des Rotationskreises der Substrate (5) angeordnetem thermischen Verdampfer (10).

2. Vakuum-Plasma-Beschichtungsanlage nach Anspruch 1, **dadurch gekennzeichnet, daß** der Vakuum-Lichtbogenverdampfer unterhalb des thermischen Verdampfers (10) angeordnet ist.

3. Vakuum-Plasma-Beschichtungsanlage nach Anspruch 1 oder 2, **dadurch gekennzeichnet, daß** der Vakuum-Lichtbogenverdampfer (14) radial außerhalb des Rotationskreises der Substrate angeordnet ist.

4. Vakuum-Plasma-Beschichtungsanlage nach Anspruch 3, **dadurch gekennzeichnet, daß** der Vakuum-Lichtbogenverdampfer (14) in die Wandung (2) der Vakuumkammer (1) integriert ist, vorzugsweise derart, daß die Verdampfungsoberfläche im wesentlichen in der Ebene der inneren Wandfläche der Vakuumkammer (1) liegt.

5. Vakuum-Plasma-Beschichtungsanlage nach Anspruch 1 oder 2, **dadurch gekennzeichnet, daß** der Vakuum-Lichtbogenverdampfer (12) innerhalb des Rotationskreises der Substrate (5) angeordnet ist.

6. Vakuum-Plasma-Beschichtungsanlage nach einem der Ansprüche 1 bis 5, **dadurch gekennzeichnet, daß** die Verdampfungsfläche des Vakuum-Lichtbogenverdampfer (12, 14) geometrisch eine rechteckige, runde oder polygonale Form aufweist.

7. Vakuum-Plasma-Beschichtungsanlage nach einem der Ansprüche 1 bis 6, **dadurch gekennzeichnet, daß** in der optischen Achse zwischen dem thermischen Verdampfer (10) und dem Vakuum-Lichtbogenverdampfer (12, 14) eine Dampfblende angeordnet ist.

8. Vakuum-Plasma-Beschichtungsanlage nach einem der Ansprüche 1 bis 6, **dadurch gekennzeichnet, daß** die Vakuumkammer im wesentlichen in eine obere Hälfte mit mindestens einem thermischen Verdampfer (10) und in eine untere Hälfte mit mindestens einem Vakuum-Lichtbogenverdampfer (12, 14) aufgeteilt ist und daß zwischen diesen Räumen eine großflächige Dampfblende angeordnet ist.

9. Anwendung einer Vakuum-Plasma-Beschichtungsanlage nach einem der Ansprüche 1 bis 8 zur Abscheidung mehrerer Schichten auf dem Substrat, wobei die Materialien, die vorteilhaft thermisch verdampft werden können, aus dem thermischen Verdampfer (10) verdampft werden und die thermisch nicht oder nur schwierig verdampfbaren Materialien von dem Vakuum-Lichtbogenverdampfer (12, 14) verdampft werden.

10. Anwendung nach Anspruch 9, **dadurch gekennzeichnet, daß** zur Abscheidung einer elektromagnetischen Schutzschicht auf einem Substrat zuerst als elektrisch leitende Schicht aus dem thermischen Verdampfer Kupfer oder Aluminium verdampft und auf dem Substrat abgeschieden wird und darauf als Korrosionsschutzschicht von dem Vakuum-Lichtbogenverdampfer (12, 14) Nickel, Chrom oder Nickel-Chrom verdampft und auf dem Substrat abgeschieden wird.

11. Anwendung nach Anspruch 9 oder 10, **dadurch gekennzeichnet, daß** aus dem thermischen Verdampfer und vom Vakuum-Lichtbogenverdampfer (12, 14) gleichzeitig unterschiedliche Materialien verdampft werden.

12. Anwendung nach Anspruch 9 oder 10, **dadurch gekennzeichnet, daß** während der Verdampfung aus dem thermischen Verdampfer (10) der Vakuum-Lichtbogenverdampfer (12, 14) zur Erzeugung eines Plasmas innerhalb der Vakuumkammer in Betrieb ist, wobei das Abscheiden von Material auf den Substraten vom Vakuum-Lichtbogenverdampfer (12, 14) durch Leistungsreduzierung und/oder Blendenanordnung vermieden wird.

## Claims

1. Vacuum plasma coating system consisting of a horizontal vacuum chamber (1), a substrate holder (6) arranged therein, by means of which substrates (5) rotate about at least one horizontal axis (4) during the coating, at least one vacuum arc evaporator (12, 14), and at least one thermal evaporator (10) arranged inside the rotation circle of the substrates (5).

2. Vacuum plasma coating system according to Claim 1, **characterized in that** the vacuum arc evaporator is arranged below the thermal evaporator (10).

3. Vacuum plasma coating system according to Claim 1 or 2, **characterized in that** the vacuum arc evaporator (14) is arranged radially outside the rotation circle of the substrates.

4. Vacuum plasma coating system according to Claim 3, **characterized in that** the vacuum arc evaporator (14) is integrated in the wall (2) of the vacuum chamber (1), advantageously so that the evaporation surface lies substantially in the plane of the inner wall face of the vacuum chamber (1).

5. Vacuum plasma coating system according to Claim 1 or 2, **characterized in that** the vacuum arc evaporator (12) is arranged inside the rotation circle of the substrates (5).

6. Vacuum plasma coating system according to one of Claims 1 to 5, **characterized in that** the evaporation face of the vacuum arc evaporator (12, 14) geometrically has a rectangular, round or polygonal shape.

7. Vacuum plasma coating system according to one of Claims 1 to 6, **characterized in that** a vapour shield is arranged in the optical axis between the thermal evaporator (10) and the vacuum arc evaporator (12, 14).

8. Vacuum plasma coating system according to one of Claims 1 to 6, **characterized in that** the vacuum chamber is substantially divided into an upper half with at least one thermal evaporator (10), and into a lower half with at least one vacuum arc evaporator (12, 14), and **in that** a large-area vapour shield is arranged between these spaces.

9. Use of a vacuum plasma coating system according to one of Claims 1 to 8 for depositing a plurality of layers on the substrate, the materials which can advantageously be thermally evaporated being evaporated from the thermal evaporator (10), and the materials which cannot be thermally evaporated or which are difficult to thermally evaporate being evaporated by the vacuum arc evaporator (12, 14).

10. Use according to Claim 9, **characterized in that** in order to deposit an electromagnetic protection layer on a substrate, copper or aluminium is firstly evaporated from the thermal evaporator and deposited on the substrate as an electrically conductive layer, and nickel, chromium or nickel-chromium is thereupon evaporated by the vacuum arc evaporator (12, 14) and deposited on the substrate as a corrosion protection layer.

11. Use according to Claim 9 or 10, **characterized in that** different materials are evaporated simultaneously from the thermal evaporator and by the vacuum arc evaporator (12, 14).

12. Use according to Claim 9 or 10, **characterized in that** during the evaporation from the thermal evaporator (10), the vacuum arc evaporator (12, 14) is in operation for generating a plasma inside the vacuum chamber, the deposition of material on the substrates by the vacuum arc evaporator (12, 14) being avoided by power reduction and/or a shield arrangement.

## Revendications

1. Dispositif pour le revêtement sous vide assisté par plasma composé d'une chambre sous vide horizontale (1), d'un support de substrat (6) disposé dans celle-ci à l'aide duquel les substrats (5) sont mis en rotation pendant l'opération de revêtement autour d'au moins un axe horizontal (4), d'au moins un vaporisateur à arc électrique sous vide (12, 14) et d'au moins un vaporisateur thermique (10) disposé à l'intérieur du cercle de rotation des substrats (5).

2. Dispositif pour le revêtement sous vide assisté par plasma selon la revendication 1, **caractérisé en ce que** le vaporisateur à arc électrique sous vide est disposé sous le vaporisateur thermique (10).

3. Dispositif pour le revêtement sous vide assisté par plasma selon la revendication 1 ou 2, **caractérisé en ce que** le vaporisateur à arc électrique sous vide (14) est disposé à l'extérieur du cercle de rotation des substrats dans le sens radial.

4. Dispositif pour le revêtement sous vide assisté par plasma selon la revendication 3, **caractérisé en ce que** le vaporisateur à arc électrique sous vide (14) est intégré dans la paroi (2) de la chambre sous vide (1), de préférence de telle manière que la surface de vaporisation se trouve pour l'essentiel dans le plan de la surface de paroi intérieure de la chambre sous vide (1).

5. Dispositif pour le revêtement sous vide assisté par plasma selon la revendication 1 ou 2, **caractérisé en ce que** le vaporisateur à arc électrique sous vide (12) est disposé à l'intérieur du cercle de rotation des substrats (5).

6. Dispositif pour le revêtement sous vide assisté par plasma selon l'une des revendications 1 à 5, **caractérisé en ce que** la surface de vaporisation du vaporisateur à arc électrique sous vide (12, 14) présente une forme géométrique rectangulaire, ronde ou polygonale.

7. Dispositif pour le revêtement sous vide assisté par plasma selon l'une des revendications 1 à 6, **caractérisé en ce qu'**un obturateur à vapeur est disposé dans l'axe optique entre le vaporisateur thermique (10) et le vaporisateur à arc électrique sous vide (12, 14).

8. Dispositif pour le revêtement sous vide assisté par plasma selon l'une des revendications 1 à 6, **caractérisé en ce que** la chambre sous vide est divisée pour l'essentiel en une moitié supérieure comprenant au moins un vaporisateur thermique (10) et en une moitié inférieure comprenant au moins un vaporisateur à arc électrique sous vide (12, 14) et qu'un obturateur à vapeur à la surface étendue est disposé entre ces espaces.

9. Utilisation d'un dispositif pour le revêtement sous vide assisté par plasma selon l'une des revendications 1 à 8 pour déposer plusieurs couches sur le substrat, les matériaux qui peuvent de préférence être vaporisés par voie thermique étant vaporisés à partir du vaporisateur thermique (10) et les matériaux qui ne peuvent pas ou seulement difficilement être vaporisés par voie thermique étant vaporisés par le vaporisateur à arc électrique sous vide (12, 14).

10. Utilisation selon la revendication 9, **caractérisée en ce que** pour déposer une couche de protection électromagnétique sur un substrat, on commence par vaporiser du cuivre ou de l'aluminium à partir du vaporisateur thermique en tant que couche conductrice d'électricité puis à les déposer sur le substrat puis la couche de protection anticorrosion est ensuite réalisée en vaporisant du nickel, du chrome ou du nickel-chrome depuis les vaporisateurs à arc électrique sous vide (12, 14) et en le déposant sur le substrat.

11. Utilisation selon la revendication 9 ou 10, **caractérisée en ce que** différents matériaux sont vaporisés simultanément du vaporisateur thermique et du vaporisateur à arc électrique sous vide (12, 14).

12. Utilisation selon la revendication 9 ou 10, **caractérisée en ce que** pendant la vaporisation à partir du vaporisateur thermique (10), le vaporisateur à arc électrique sous vide (12, 14) est en fonctionnement en vue de générer un plasma à l'intérieur de la chambre sous vide, la déposition du matériau sur les substrats par le vaporisateur à arc électrique sous vide (12, 14) étant empêchée par une réduction de la puissance et/ou un arrangement obturateur.
